# EUROPEAN PATENT SPECIFICATION

(11) **EP 0 997 637 B1**
(45) Date of publication and mention of the grant of the patent: **27.10.2004**
(21) Application number: 99120913.1
(22) Date of filing: 29.10.1999
(51) Int. Cl.: F02P 3/055

(54) **An ignition apparatus and an ignition control system of an internal combustion engine and IGBT of an internal combustion engine**
Zündvorrichtung und Zündsteuerungsystem eines Verbrennungsmotors und IGBT von eines Verbrennungsmotors
Dispositif d'allumage et système de pilotage d'allumage d'un moteur à combustion interne et IGBT d'un moteur à combustion interne

(30) Priority: 30.10.1998 JP 30983698
(43) Date of publication of application: 03.05.2000
(73) Proprietor: Hitachi, Ltd., Chiyoda-ku, Tokyo 101-8010 (JP); Hitachi Car Engineering Co., Ltd., Hitachinaka-shi, Ibaraki 312-0062 (JP)
(72) Inventor: Fukatsu, Katsuaki, Naka-gun, Ibaraki 319-2104 (JP); Kobayashi, Ryoichi, Naka-gun, Ibaraki 319-1106 (JP); Ito, Takashi, Naka-gun, Ibaraki 311-0105 (JP)
(74) Representative: Beetz & Partner Patentanwälte

(56) References cited:
- US-A- 5 500 619
- US-A- 5 664 550
- US-A- 5 723 916
- US-A- 5 775 310

## Description

### Background of the Invention:

The present invention relates to an ignition apparatus, to an ignition control system of an internal combustion engine and to an IGBT (an insulation gate type bipolar transistor) of an internal combustion engine. In particular, the invention relates to an ignition apparatus and an ignition control system of an internal combustion engine and IGBT of an internal combustion engine in which an anti-noise performance and an anti-surge performance are improved.

A technique in which an IGBT's (an insulation gate type bipolar transistor) is used in an ignition apparatus of an internal combustion engine and to this IGBT a protection function is provided is disclosed in Japanese application patent laid-open publication No. Hei 2-171904. This relates to a technique in which the IGBT is protected from a circuit outside the IGBT chip. Many techniques similar to the above stated technique have been published.

An ignition apparatus of an internal combustion engine is used in a severe and special environment with high voltage surges and noise An IGBT chip main body having a function for safe-guarding this IGBT is constituted in a chip.

In particularly, the present invention is devised to handle noise and surges as an ignitor in an ignition apparatus of the internal combustion engine. This technique is not shown in the conventional technique.

The main current of the ignitor in the recent year is one which is provided in an ignition coil as one body according to the requirements of an intensive performance of the functions and a small size and a light weight of the ignition system.

Further, a large current performance of the IGBT according to the requirements of a high output, a high energy performance, and a small size of the ignition coil are desired. On the other hand low electric power consumption including an ignitor drive circuit in an ECU (an engine control unit) is desired. Correspond to this, as a switching element is now an IGBT (the insulation gate type bipolar transistor) preferred instead of a bipolar power transistor.

Since the ignitor is installed in an interior portion as the ignition coil wherein the high voltage is generated and since the ignitor must endure an environment having an unprecedented level of noise, noise frequencies and surges, there is a problem of improving mechanisms for protecting an IGBT itself including its peripheral circuit against the above stated noise and surges.

### Summary of the Invention:

An object of the present invention is to provide an ignition apparatus and an ignition control system of an internal combustion engine and an IGBT (an insulation gate type bipolar transistor) of an internal combustion engine in which the IGBT withstands strong surges and noise and to provide an ignition apparatus and an ignition control system of an internal combustion engine using this IGBT.

The above stated object of the present invention is attained by an ignition apparatus of an internal combustion engine comprising a circuit for controlling a primary current of an ignition coil of the internal combustion engine according to a signal from outside, a part of said circuit is formed according to an insulation gate type bipolar transistor (IGBT), and an interior gate electrode of said IGBT is constituted by a cell having two different shapes, namely stripe shape and mesh shape.

Further, the above stated object of the present invention is attained by an ignition control system comprising an ignition apparatus having a circuit for controlling a primary current of an ignition coil of an internal combustion engine in response to a signal from outside and a part of said circuit is formed by an IGBT (an insulation gate type bipolar transistor) and further a gate electrode of said IGBT has a cell having two different shapes namely stripe shape and mesh shape, and a control apparatus for a fuel amount for supplying fuel to the internal combustion engine and a control apparatus for controlling an ignition of the internal combustion engine.

Further, the above stated object of the present invention is attained by an insulation gate type bipolar transistor (IGBT) in which an internal portion gate electrode is constituted by a cell having two different shapes, namely stripe shape and mesh shape.

To this, in the stripe structure which is the wiring method of the chip used in known countermeasures in IGBT's, in order to reduce the parasitic resistance of the above stated gate, the wiring is formed also in mesh structure. By attaining the reduction of the parasitic resistance which is the feature of the mesh structure, the IGBT is made strong against destruction.

### Brief Description of Drawing:

Fig. 1 is a basic equivalent circuitry of one embodiment of IGBT of an ignition apparatus of an internal combustion engine according to the present invention ;
Fig. 2 is a detail of the basic equivalent circuitry of one embodiment of IGBT of an ignition apparatus of an internal combustion engine according to the present invention;
Fig. 3 is an appearance view of one embodiment IGBT chip of an ignition apparatus of an internal combustion engine according to the present invention;
Fig. 4 is a mesh structure view of one embodiment IGBT chip of an ignition apparatus of an internal combustion engine according to the present invention;
Fig. 5 is a stripe structure view of one embodiment IGBT chip of an ignition apparatus of an internal combustion engine according to the present invention;
Fig. 6 is an equivalent circuitry of an ignition apparatus of an internal combustion engine according to the present invention;
Fig. 7 is a detail view of the equivalent circuitry of an ignition apparatus of an internal combustion engine according to the present invention; and
Fig. 8 is a circuitry showing a whole ignition apparatus of an internal combustion engine according to the present invention.

### Description of the Invention:

Hereinafter, one embodiment according to the present invention will be explained referring to the drawings.

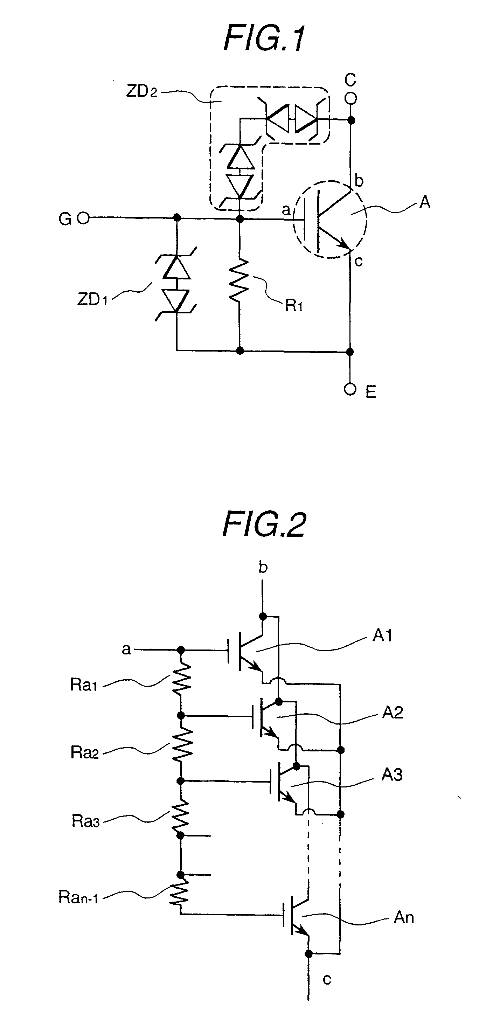

First of all, referring to Fig.1 to Fig. 5, one embodiment of an ignition apparatus and an ignition control system of an internal combustion engine and IGBT of an internal combustion engine will be explained.

Fig. 1 shows one example of an equivalent circuitry of IGBT of an ignition apparatus of an internal combustion engine. It has three terminals comprised of a gate electrode G, a collector electrode C, and an emitter electrode E. Between the gate electrode G and the emitter electrode E, a protecting Zener diode ZD 1 and a resistor R1 are connected.

Between the collector electrode C and the gate electrode G, to clamp a high voltage (a flyback voltage) which is generated at shutdown of a primary current of an ignition coil, a binary direction type Zener diode using a poly-silicon is provided.

Fig. 2 shows a detail of the IGBT main body portion A. IGBT main body portion A of the equivalent circuitry shown in Fig. 1, as shown in Fig. 2, is constituted by connecting in parallel partial IGBT's Al-An. Between the respective gate electrode of these partial IGBT's Al-An, there exist resistors Ra1-Ran-1 due to the wiring connection .

When to the gate electrode portion of IGBT a surge or noise having a speedy pulse (a high frequency pulse) is applied the partial IGBT's Al-An can not follow the speedy pulse (the high frequency pulse) in a synchronized manner because of the wiring resistance of Ral-Ran-1.

Since the partial IGBT's are driven successively with A1, A2, A3, ..., An, in a whole IGBT, the partial IGBT's are driven locally, and there occurs a case in which destruction etc occurs according to the thermal load of the partial IGBT's.

The present invention aims that the wiring resistance Ra1-Ran-1 formed between the respective partial IGBT gate electrodes, which becomes a scattering cause of the drive start speed of the above stated partial IGBT's can be reduced.

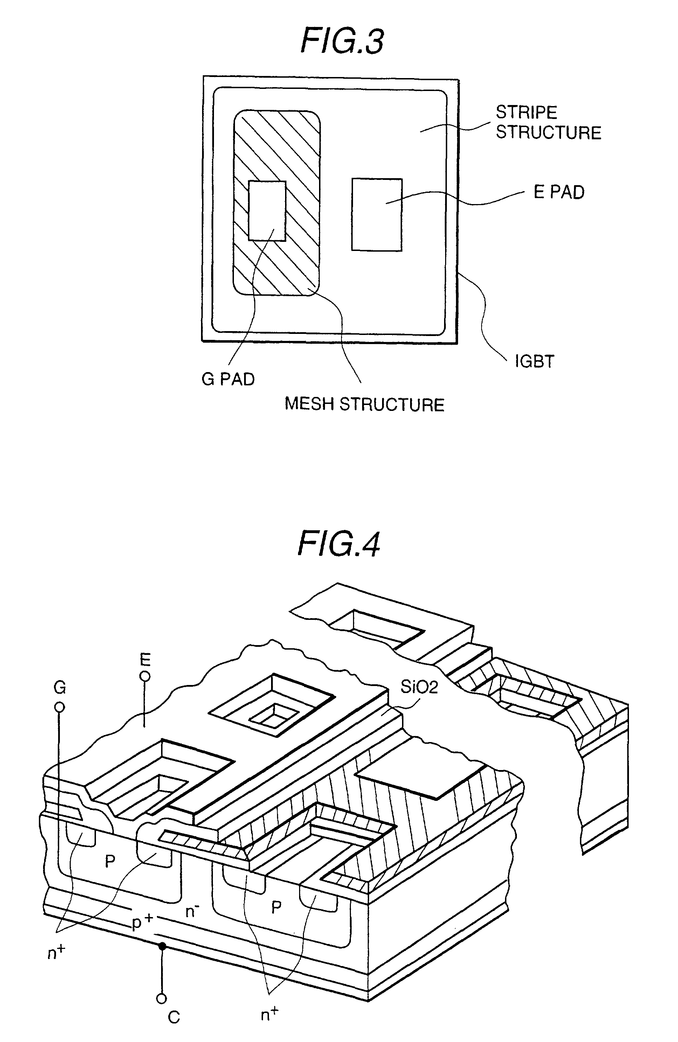

One embodiment of the reduction of the resistance between the partial IGBT's will be explained referring to Fig. 3 to Fig. 5. Fig. 3 shows an appearance view of IGBT chip which corresponds to the equivalent circuitry shown in Fig. 1 and is seen from a surface of the chip.

On a chip surface, a gate (G) pad made by A1 electrode and an emitter (E) pad are arranged. They are connected to the outside using A1 wire supersonic welding (bonding). Further, not shown in figure, a rear face of the chip has a collector electrode and a metal layer.

Conventionally, a whole chip has a wiring pattern of either mesh structure or stripe structure. Most conventional IGBT's employ the stripe structure to improve the latch-up. However, the mesh structure has merits such as a small performance by reducing specific resistance.

According to the present invention, by making practical application of all of the above stated respective merits, an IGBT having the improved noise resistance performance and the improved surge resistance performance is rendered. In an embodiment, forming an area of less than 50 % with mesh structure, gives a good result.

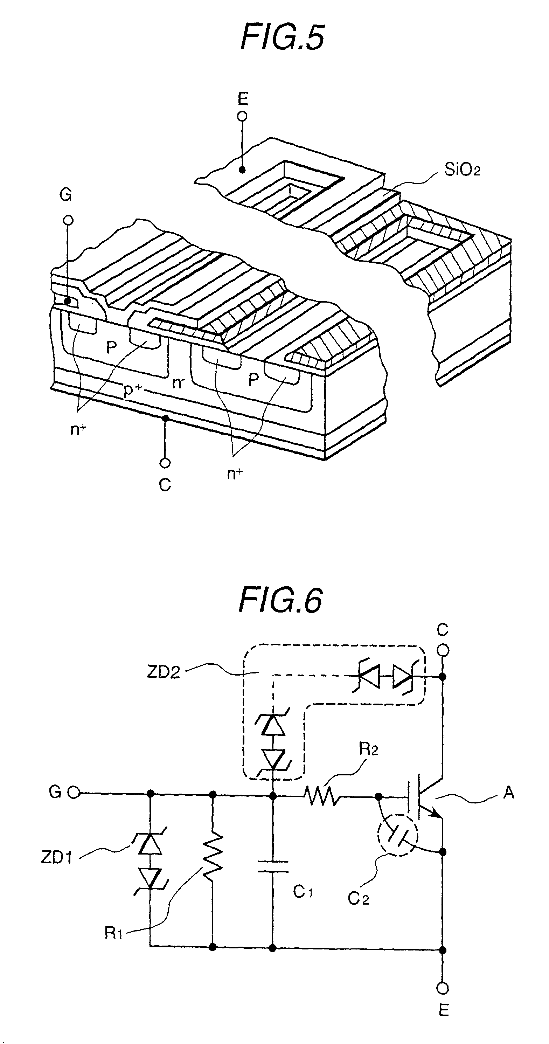

Fig. 4 shows a structural view showing the wiring of the mesh structure, and Fig. 5 shows the stripe structure. In Fig. 4, on a basic structure of pnpn type IGBT a gate wiring which is insulated according to SiO₂ insulation layer is arranged latticed and an emitter wiring which is connected to p layer is wired similarly to a gate wiring.

The stripe construction shown in Fig. 5, compared to the mesh construction shown in Fig. 4, is not wired with lattice shape but is wired with the stripe shape, and at a corner portion a broadening of a substantial width of n⁺ emitter area is removed and also an electrode contact area of p⁺ emitter is made large, so that npn type transistor operation according to the Hall current can be suppressed. The area of wiring of the stripe construction is smaller than that of the mesh construction. Namely, p⁺ emitter area is not broadened at the corner portion (the corner portion is small). Further, the contact area of p⁺ emitter electrode is broadened and the operation of npn transistor can be suppressed.

According to the present invention, to reduce the wiring resistance Ra1-Pan-1 shown in Fig. 2, the mesh construction is provided at a part of the gate wiring.

Next, in Fig. 6, compared to the basic equivalent circuit of IGBT shown in Fig. 1, a condenser C1 and a resistor R2 are added. The condenser C2 is a condenser which always exists parasitically between the gate electrode G and the emitter electrode E. The condenser C1 constitutes a high pass filter and the resistor R2 constitutes a CR (condenser-resistor) low pass filter circuit with the condenser C2.

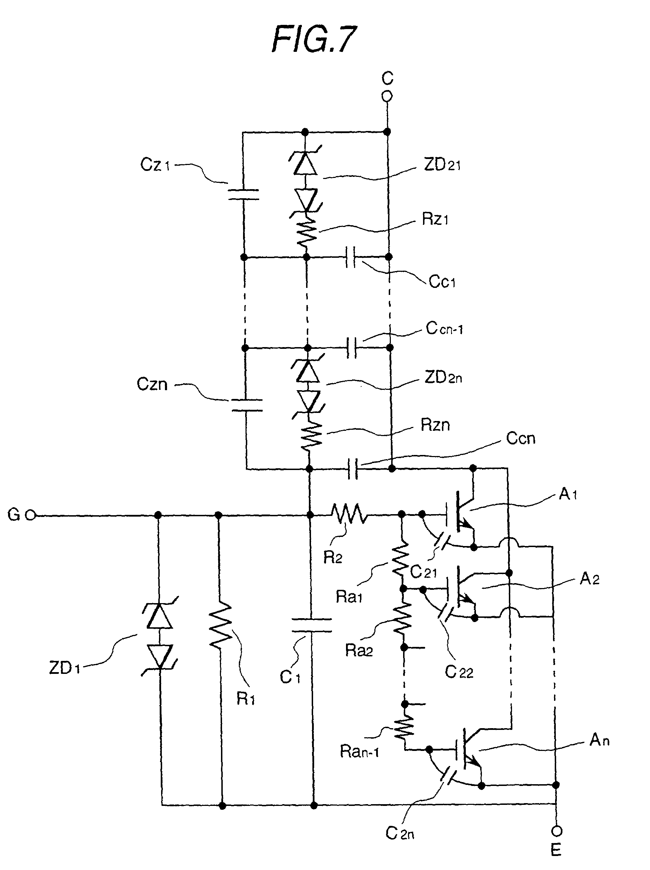

Fig. 7 shows a detail of the equivalent circuitry of an IGBT using the present invention. ZD2 shown in Fig. 1 and Fig. 6 has a construction shown in Fig. 7. The resistance parts Rz1-Rzn are arranged in series to the binary direction Zener diodes ZD21-ZD2n. Cz1-Czn are arranged in parallel, respectively, and Cc1-Ccn exist as floating condensers. In an IGBT used as the ignitor, in particularly the high voltage having the rapid speed (the high frequency) is generated at the collector portion.

Further, since the collector portion is connected to the ignition coil which generates the high voltage, the surges and noise are superposed easily from the ignition coil, and rapid speed surge which is superposed to the collector portion is superposed to the gate portion of the IGBT through the condenser combination portions of Cz1-Czn and Cc1-Ccn shown in Fig. 7.

Since the surge being superposed by this route is impossible to be countermeasured by outside circuitry of the IGBT chip, it is necessary to perform the resistant weight-up within the whole element as shown in the present invention, by forming the operation balance of the partial IGBT's.

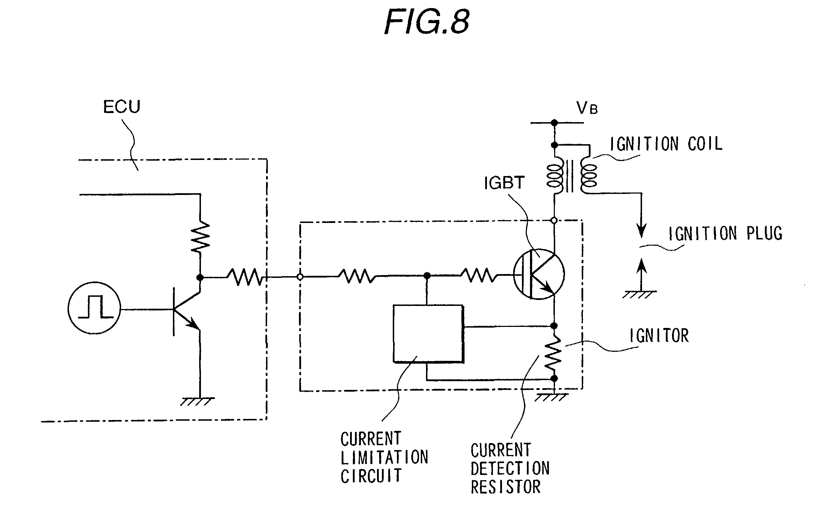

Fig. 8 is a circuitry of the ignition apparatus using an IGBT according to the present invention.

Another embodiment will be explained hereinafter.

An ignition control system comprises an ignition apparatus having a circuit for controlling a primary current of an ignition coil of an internal combustion engine in response to a signal from outside. A part of said circuit is formed by an IGBT (an insulation gate type bipolar transistor). A gate electrode of said IGBT has a cell having two different shapes. A control of a fuel amount for supplying to the internal combustion engine and a control apparatus for controlling an ignition of the internal combustion engine are provided.

According to the present invention, the withstanding properties against surges and noise etc. can be improved remarkably, and the ignitor using an above IGBT has high reliability.

Further, since it is unnecessary to provide a protection function for the IGBT against surges and noise etc. by peripheral circuitry, a small size and low cost ignition apparatus (the ignitor) can be obtained.

## Claims

1. An ignition apparatus of an internal combustion engine comprising a circuit for controlling a primary current of an ignition coil of the internal combustion engine according to a signal from an outside, said circuit has an insulation gate type bipolar transistor (IGBT),
wherein an interior gate electrode of said transistor (IGBT) is constituted by a cell having two different shapes, **characterized in that** one of them is a stripe shape cell and another of them is a mesh shape cell.

2. An ignition apparatus of an internal combustion engine according to claim 1, **characterized in that**
said stripe shape cell is main and said mesh shape cell is subordinate.

3. An ignition apparatus of an internal combustion engine according to claim 1, **characterized in that**
said IGBT has a voltage clamp use Zener diode which is provided between a collector electrode and a gate electrode in an internal portion thereof.

4. An ignition apparatus of an internal combustion engine according to claim 3, **characterized in that**
the ignition apparatus comprises
a condenser (C1) which is provided between said gate electrode and an emitter electrode, and
a resistor (R2) connected to said gate voltage; and
said resistor is provided to a side of said gate electrode from said condenser and is provided to a side of said gate electrode form said Zener diode condenser (ZD2).

5. An ignition control system of an internal combustion engine comprising:
an ignition apparatus according to one of the preceeding claims; and
a control of apparatus for controlling a fuel amount for supplying to the internal combustion engine and a control apparatus for controlling an ignition of the internal combustion engine.

6. An insulation gate type bipolar transistor (IGBT) of an internal combustion engine in which an internal portion gate electrode is constituted by a cell having two different shapes, wherein one of them is a stripe shape cell and another of them is a mesh shape cell.

## Patentansprüche

1. Zündvorrichtung einer Brennkraftmaschine mit einer Schaltung zur Steuerung eines Primärstroms einer Zündspule der Brennkraftmaschine nach Maßgabe eines Signals von außen, wobei die Schaltung einen Bipolartransistor mit isoliertem Gate (IGBT) hat, wobei eine innere Gateelektrode des Transistors (IGBT) durch eine Zelle gebildet ist, die zwei unterschiedliche Formen hat, **dadurch gekennzeichnet, dass** eine davon eine streifenförmige Zelle und eine andere eine gitterförmige Zelle ist.

2. Zündvorrichtung einer Brennkraftmaschine nach Anspruch 1, **dadurch gekennzeichnet, dass**
die streifenförmige Zelle übergeordnet und die gitterförmige Zelle untergeordnet ist.

3. Zündvorrichtung einer Brennkraftmaschine nach Anspruch 1, **dadurch gekennzeichnet, dass**
der IGBT eine zur Spannungsbegrenzung verwendete Zener-Diode hat, die zwischen einer Elektroelektrode und einer Gateelektrode im inneren Bereich desselben vorgesehen ist.

4. Zündvorrichtung einer Brennkraftmaschine nach Anspruch 3,
**dadurch gekennzeichnet, dass**
die Zündvorrichtung aufweist
einen Kondensator (C1), der zwischen der Gateelektrode und der Emitterelektrode vorgesehen ist, und
einen Widerstand (R2), der mit der Gatespannung verbunden ist, und
wobei der Widerstand an der gateseitigen Elektrode des Kondensators und an der gateseitigen Elektrode der Zener-Diode (ZD2) liegt.

5. Zündsteuerungssystem einer Brennkraftmaschine mit:
einer Zündvorrichtung nach einem der vorherigen Ansprüche, und
einer Steuerungsvorrichtung zur Steuerung einer Kraftstoffmenge zum Zuführen zur Brennkraftmaschine und eine Steuerungsvorrichtung zum Steuern der Zündung der Brennkraftmaschine.

6. Bipolarer Transistor mit isoliertem Gate (IGBT) einer Brennkraftmaschine, bei dem die Gateelektrode im inneren Bereich durch eine Zelle mit zwei unterschiedlichen Formen gebildet ist, von denen eine eine streifenförmige Zelle und die andere eine gitterförmige Zelle ist.

## Revendications

1. Un dispositif d'allumage d'un moteur à combustion interne comprenant un circuit permettant de contrôler un courant primaire d'une bobine d'allumage du moteur à combustion interne selon un signal provenant de l'extérieur, ledit circuit possède un transistor bipolaire de type à grille isolée, (IGBT),
dans lequel
une grille de transistor interne dudit transistor IGBT est constituée par une cellule ayant deux formes différentes,
**caractérisé en ce que**
l'une d' elles est une cellule en forme de ruban et l'autre d'entre elles est une cellule en forme de maille.

2. Un dispositif d'allumage d'un moteur à combustion interne selon la revendication 1, **caractérisé en ce que**
ladite cellule en forme de ruban est une cellule principale et ladite cellule en forme de maille est une cellule secondaire.

3. Un dispositif d'allumage d'un moteur à combustion interne selon la revendication 1, **caractérisé en ce que**
ledit transistor IGBT possède une diode Zener à voltage imposé qui est disposée entre une électrode de collecteur et une grille de transistor dans une partie interne de celui-ci.

4. Un dispositif d'allumage d'un moteur à combustion interne selon la revendication 3, **caractérisé en ce que**
le dispositif d'allumage comprend
un condensateur (C1) qui est disposé entre ladite grille de transistor et une électrode d'émetteur, et
une résistance (R2) connectée à ladite tension de grille ; et
ladite résistance est disposée d'un côté de ladite grille de transistor à partir dudit condensateur et est disposée d'un côté de ladite grille de transistor à partir dudit condensateur à diode Zener (ZD2).

5. Un système de pilotage d'allumage d'un moteur à combustion interne comprenant :
un dispositif d'allumage selon l'une des revendications précédentes ;
un dispositif de contrôle permettant de contrôler une quantité de carburant devant être fournie au moteur à combustion interne et un dispositif de pilotage permettant de piloter un allumage du moteur à combustion interne.

6. Un transistor bipolaire de type à grille isolée IGBT d'un moteur à combustion interne dans lequel une partie interne de la grille de transistor est constituée par une cellule ayant deux formes différentes, dans laquelle l'une d'entre elles est une cellule en forme de ruban et une autre d'entre elles est une cellule en forme de maille.
